# EUROPÄISCHE PATENTANMELDUNG

(11) **EP 4 697 865 A1**
(43) Veröffentlichungstag der Anmeldung: **18.02.2026**
(21) Anmeldenummer: 24194551.8
(22) Anmeldetag: 14.08.2024
(51) Int. Cl.: H05K 1/02

(54) **LEITERPLATTE MIT MINDESTENS EINEM DARAUF GELÖTETEN BAUELEMENT**

(71) Anmelder: Siemens Aktiengesellschaft, 80333 München (DE)
(72) Erfinder: Frühauf, Peter, 14612 Falkensee (DE); Heimann, Matthias, 14469 Potsdam (DE); Knofe, Rüdiger, 14513 Teltow (DE); Müller, Bernd, 16259 Falkenberg (DE); Strogies, Jörg, 14163 Berlin (DE); Wilke, Klaus, 12527 Berlin (DE)
(74) Vertreter: Siemens Patent Attorneys

(57) **Zusammenfassung**

Leiterplatte mit mindestens einem darauf gelötetem Bauelement (4), wobei das Bauelement (6) mindestens an einer Lötstelle (8), die auf einer Kontaktierungsfläche in der Leiterplattenoberfläche (8) liegt, mittels eines Lotmaterials (10) mit der Leiterplatte (2) verbunden ist, dadurch gekennzeichnet, dass um die Kontaktierungsfläche (8) ein Vertiefungsrinne (12) in der Leiterplatte (2) verläuft, die die Kontaktierungsfläche (8) zu mindestens 50 % ihrer Umfangslinie (14) in einem Abstand (16) umläuft, der nicht größer als der maximale Durchmesser (18) der Kontaktierungsfläche (8) ist.

## Beschreibung

Die Erfindung betrifft eine Leiterplatte mit mindestens einem darauf gelöteten Bauelement nach dem Oberbegriff des Patentanspruchs 1.

Die Entkopplung von thermomechanischen Belastungen in elektronischen Bauelementen wie beispielsweise bei Leiterplatten mit darauf montierten Bauelementen, insbesondere einer sogenannten SMD (Surface-monted-devices) ist ein bekanntes Problem in der Elektronikherstellung. Wenn Bauelemente wie Halbleiterchips, Mikroprozessoren oder andere elektronische Komponenten miteinander verbunden werden, können Unterschiede in den Wärmeausdehnungskoeffizienten in Kombination mit Temperaturänderungen während des Betriebs und während der Herstellung der elektronischen Komponenten dazu führen, dass sich die Bauteile und/oder das Lotmaterial bzw. die Leiterplatten während des Betriebs ausdehnen oder zusammenziehen. Diese hieraus resultierenden thermomechanischen Spannungen können zu Rissen, Brüchen oder anderen Schäden an den Bauelementen und somit an der gesamten Leiterplattenkomponente führen. Dies beeinträchtigt die Zuverlässigkeit und Lebensdauer der elektronischen Geräte erheblich. Bisher werden diese Probleme beispielsweise durch die Entwicklung von Fügetechniken, Materialen oder Konstruktionsprinzipien, die die thermomechanischen Belastungen reduzieren oder kompensieren können angegangen.

Nach dem Stand der Technik sind insbesondere Maßnahmen im Hinblick auf eine Anpassung der unterschiedlichen Ausdehnungskoeffizienten der verwendeten Materialien getroffen worden. Auch konstruktive Maßnahmen, bei denen mehrere verschiedene Materialien miteinander kombiniert werden, die jeweils sich annähernde Ausdehnungskoeffizienten aufweisen und somit ein Gradient für die Ausdehnungskoeffizienten erzielt wird, ist bereits hinreichend beschrieben und eingesetzt worden. Dennoch werden insbesondere für Baugruppen, also Leiterplatten mit Bauelementen, die für sicherheitstechnisch hochrelevante Einsätze ausgelegt sind, oder bei Baugruppen, die beispielsweise in der Elektromobilität hohen thermischen Schwankungen ausgesetzt sind, während des Betriebes, ausgesprochen hohe Anforderungen an die Verträglichkeit und an die Sicherheit der Fügeverbindungen zwischen Bauelementen und Leiterplatten in den elektronischen Baugruppen gestellt. Dies wird mit den bisher bekannten und beschriebenen Maßnahmen zur Vermeidung der Problematik bezüglich der unterschiedlichen Ausdehnungskoeffizienten bisher nur unzureichend entgegengewirkt.

Daher besteht die Aufgabe der Erfindung darin, eine Leiterplatte mit einem darauf montierten Bauelement bereitzustellen, die gegenüber dem Stand der Technik eine bessere Verträglichkeit gegenüber Temperaturschwankungen während der Herstellung und des Betriebs der Leiterplatte aufweist.

Die Lösung der Aufgabe besteht in einer Leiterplatte mit den Merkmalen des Patentanspruchs 1.

Die erfindungsgemäße Leiterplatte weist dabei mindestens ein darauf gelötetes Bauelement auf. Hierbei ist das Bauelement an mindestens einer Lötstelle, die auf einer Kontaktierungsfläche in der Leiterplattenoberfläche liegt, mittels eines Lotmaterials mit der Leiterplatte verbunden. Die Erfindung zeichnet sich dadurch aus, dass um die Kontaktierungsfläche eine Vertiefungsrinne in der Leiterplatte verläuft, die die Kontaktierungsfläche zu mindestens 50 % ihrer Umfanglinie in einem Abstand umläuft, der nicht größer ist als der maximale Durchmesser der Kontaktierungsfläche.

Die beschriebene Vertiefungsrinne führt zu einer mechanischen Flexibilität der Leiterplatte, sodass thermische Ausdehnung an der Leiterplatte teilhabenden Materialien durch flexible Bewegung von Leiterplattenabschnitten, also den Abständen, die durch den Vertiefungsrinne umgeben sind und in denen die Kontaktierungsfläche der Leiterplatte liegt, ausgeglichen werden können. Hierzu hat sich herausgestellt, dass diese Vertiefungsrinnen einen erheblichen Teil der Kontaktierungsfläche umlaufen sollen, also einen Teil der mindestens 50 % der Umfanglinie der Kontaktierungsfläche beträgt. Die Vertiefungsrinnen darf auch nicht zu weit von der Kontaktierungsfläche entfernt verlaufen, um ihre Wirkung nicht zu stark einzubüßen. Es hat sich herausgestellt, dass ein Verlauf einen Abstand aufweist, der mehr als der maximale Durchmesser der Kontaktierungsfläche (also bei einer rechteckigen Kontaktierungsfläche die Diagonale) nicht überschreiten soll, um die beschriebene Wirkung zu erzielen.

Unter dem Begriff Lötstelle wird hierbei ein dreidimensionaler Bereich auf der Leiterplatte verstanden, der sowohl die Kontaktierungsfläche, das Leiterplattenvolumen unterhalb der Kontaktierungsfläche, das Lotmaterial und der Kontaktbereich eines Bauelementes umfasst, der von dem Kontaktmaterial umschlossen wird. Die Kontaktierungsfläche hingegen ist ein Teil der Oberfläche der Leiterplatte, die mit einer insbesondere metallischen Kontaktierung (beispielsweise einer Kupferkontaktierung) versehen ist. Diese Kontaktierungsfläche ist dabei mit einer Kontaktierungsleitung verbunden, die ebenfalls auf der Oberfläche der Leiterplatte verläuft, die jedoch auch im Falle von sogenannten PCB-Leiterplatten, die mehrere Schichten und mehrere Kontaktierungsebenen aufweisen, unterhalb der Oberfläche der Leiterplatte verlaufen kann.

Unter einer Vertiefungsrinne wird im Wesentlichen eine Ausfräsung oder Ausstanzung der Leiterplatte verstanden, wobei die Vertiefungsrinne eine Tiefe aufweist, die beispielsweise im Falle einer Ausfräsung mindestens 80 % der Leiterplattendicke beträgt. Bei einer so verhältnismäßig tiefen Ausfräsung wird gewährleistet, dass die Flexibilität der Leiterplatte durch den nicht ausgefrästen Bereich, der in der Regel noch eine Dicke von weniger als 100 µm aufweist, gewährleistet wird.

Besonders bevorzugt ist es, dass die Tiefe der Vertiefungsrinne 100 % der Leiterplattendicke beträgt. Dies bedeutet, dass die Vertiefungsrinne eine vollständige Durchstanzung, Durchschneidung oder Durchfräsung der Leiterplatte darstellt. Dies ist zum einen technologisch beispielsweise durch ein Stanzen oder ein Laserschneiden oder ein Wasserstrahlschneiden relativ unaufwändig darstellbar und es zeigt bezüglich der Flexibilität der Leiterplatte und die daraus resultierende Wirkung auf die Toleranz bezüglich unterschiedlicher Ausdehnungskoeffizienten die stärkste Wirkung.

In dem Fall, dass die Vertiefungsrinne nicht vollständig zu 100 % durchstoßen ist und mindestens 80 % der Leiterplattendicke als Vertiefung dargestellt sind, kann neben der beschriebenen Ausfräsung ebenfalls eine Durchstanzung als technologische Darstellungsmethode herangezogen werden, wonach anschließend wieder eine zusätzliche dünne Schicht im Bereich von 100 µm bis 200 µm auf die Leiterplatte aufgebracht werden kann, beispielsweise auflaminiert werden kann. Durch diese Maßnahme wird ebenfalls der Zweck bewirkt, dass eine Vertiefungsrinne eine Tiefe von mindestens 80 % der Leiterplattendicke aufweist. Dies wird dann dargestellt, wenn eben eine resttragende Schicht beispielsweise aus Kontaktierungsgründen benötigt wird.

In einer weiteren vorteilhaften Ausgestaltungsform ist die Kontaktierungsfläche rechteckig ausgestaltet und die Vertiefungsrinne verläuft mindestens an drei Seiten des Rechtecks flankierend. Auf diese Weise kann eine Flexibilität der Leiterplattenfläche, auf der die Kontaktierungsfläche sich befindet, in drei Richtungen sowie in eine sogenannte Z-Richtung senkrecht zur Leiterplatte erfolgen.

Noch zweckmäßiger ist es, dass die Kontaktierungsfläche rechteckig ausgestaltet ist und die Vertiefungsrinne an vier Seiten des Rechtecks flankierend verläuft, wobei an einer vierten Seitenlinie ein Kontaktierungssteg vorgesehen ist. Durch diese Maßnahme wird die Flexibilität der Leiterplatte im Bereich der Kontaktierungsfläche noch weiter erhöht. Dies führt jedoch auch zu einer höheren Fragilität dieses Bereichs, der lediglich über einen Kontaktierungssteg noch mit dem Rest der Leiterplatte verbunden ist. Es hat sich jedoch herausgestellt, dass in Leiterplatten aufgrund ihrer Materialeigenschaften als Kunststoff und Metallverbund durchaus eine hohe Flexibilität aufweisen und eine derartig beschriebene Konstruktion durchaus hohen Zyklusanforderungen bei hohen Temperaturgradienten bestehen kann.

Ebenfalls ist es zweckmäßig, dass die Vertiefungsrinne mehrere voneinander getrennte Abschnitte aufweist. So kann beispielsweise der Umlauf der Vertiefungsrinne um die Kontaktierungsfläche und deren Umfangslinie unterbrochen sein. Sie kann jedoch auch bis auf einen Steg um die Umfangslinie der Kontaktierungsfläche herum verlaufen und ein zweiter Abschnitt der Vertiefungsrinne vorgesehen sein, der im Wesentlichen parallel zu einer vierten Seitenlinie der Kontaktierungsfläche verläuft, wobei diese vierte Seitenlinie die Seitenlinie ist, die mit dem Steg verbunden ist. Durch diese Maßnahme wird die flexible mechanische Ausdehnung der Kontaktierungsfläche in alle vier Flächenrichtungen auf der Leiterplatte sowie in eine senkrechte Richtung zur Leiterplatte gewährleistet. Diese Maßnahme bietet ein sehr hohes Maß an Flexibilität und an Kompensationsvermögen gegenüber thermischen Spannungen in der Lötstelle.

Dabei ist die Länge des zweiten Abschnitts der Vertiefungsrinne mindestens so lang, dass der Verbindungssteg durch sie abgedeckt ist, insbesondere ist dieser Abschnitt der Vertiefungsrinne mindestens so lang wie die gesamte Länge der vierten Seitenlinie der Kontaktierungsfläche.

Weitere Ausgestaltungsformen und weitere Merkmale der Erfindung werden anhand der folgenden Figuren näher erläutert. Dabei handelt es sich um rein schematische Darstellungen und Ausgestaltungsformen, die keine Einschränkung des Schutzbereichs darstellen. Merkmale, die dieselbe Bezeichnung aufweisen, aber in unterschiedlichen Ausgestaltungsformen vorliegen, werden dabei mit denselben Bezugszeichen versehen.

Dabei zeigen:
- Figur 1: eine Darstellung nach dem Stand der Technik, wobei ein Querschnitt durch eine Lötstelle mit einem Riss im Lotmaterial beschrieben ist.
- Figur 2: eine Draufsicht auf eine Leiterplatte mit einer Kontaktierungsfläche und diese umlaufende Vertiefungsrinne,
- Figur 3: eine Draufsicht analog Figur 2 mit Vertiefungsrinne in einer alternativen Ausgestaltung,
- Figur 4: ebenfalls eine Draufsicht auf eine Leiterplatte mit wiederum einer alternativen Ausgestaltungsform von Vertiefungsrinne,
- Figur 5: einen Querschnitt durch eine Leiterplatte, bei der die Vertiefungsrinne eine Tiefe von ca. 90 % der Leiterplattendicke aufweist und

Figur 6eine dreidimensionale Darstellung des Ausschnittes V in Figur 5.

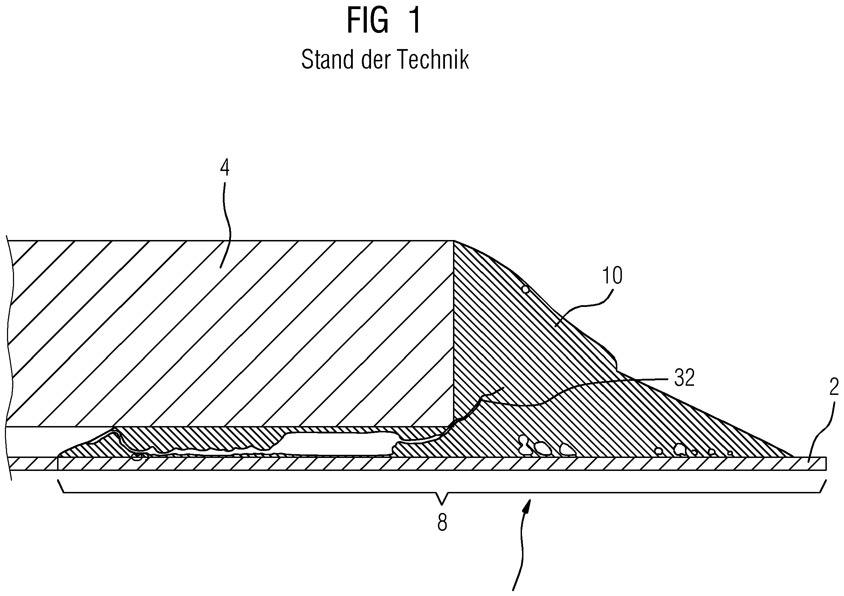

In Figur 1 ist ein Querschnitt durch eine Lötstelle 6 auf einer Leiterplatte 2 dargestellt. Dabei weist die Lötstelle 6 zum einen eine Kontaktierungsfläche 8 auf der Leiterplatte 2 auf, auf der ein Lotmaterial 10 aufgebracht ist, dass wiederum eine Kontaktierung zu einem Bauelement 4 bildet. Hierbei handelt es sich um eine Löttechnik, die auch als SMD-Technik bekannt ist. Die hier dargestellte Lötstelle 6 zeigt den Ausschnitt aus einer Leiterplatte 2 mit Bauteil 4, der bereits seit längerer Zeit im Einsatz war und dabei einer Vielzahl von Temperaturzyklen ausgesetzt war. Aus diesem Grund hat sich in dem Lotmaterial 10 ein Riss 32 gebildet, der zwar in dieser Darstellung noch nicht vollständig das Lotmaterial 10 durchläuft, der aber in naher Zukunft zum Ausfall des Bauteils bzw. der Leiterplatte insgesamt und somit der gesamten elektronischen Komponente, in der die Leiterplatte 2 eingesetzt ist, führen wird. Die Aufgabe der Erfindung besteht darin, eine Lötstelle bzw. eine Leiterplatte mit einer Lötstelle und Bauelement bereitzustellen, die gegen eine derartige Rissbildung gemäß Figur 1 des Standes der Technik besser geschützt ist als herkömmliche Anordnungen.

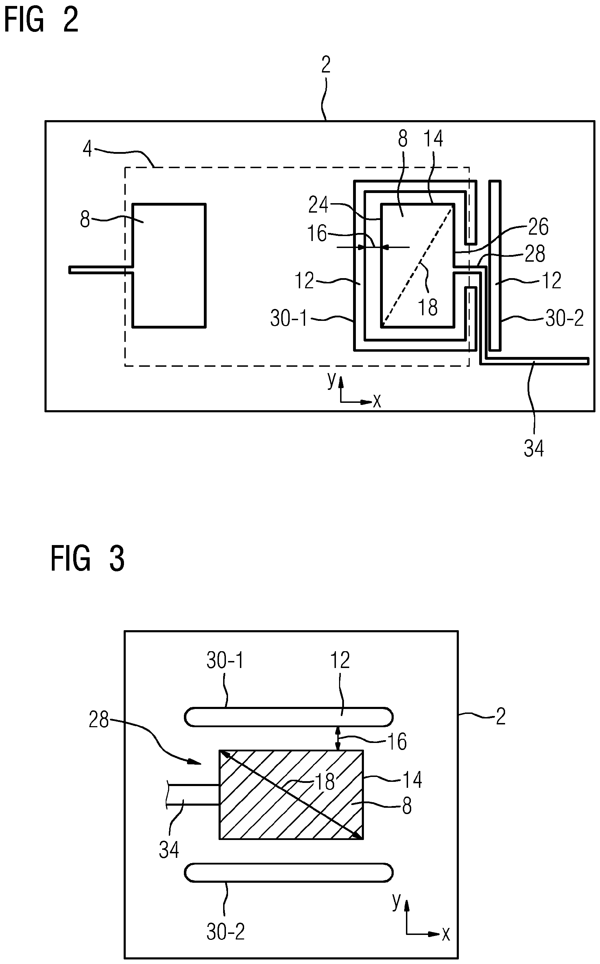

Hierzu wird anhand der schematischen Darstellung nach Figur 2 eine vorteilhafte Ausgestaltung beschrieben. In Figur 2 ist eine Draufsicht auf eine Leiterplatte 2 gegeben, in der zwei Kontaktierungsflächen 8 für ein hier durch eine gestrichelte Linie dargestelltes Bauelement angeordnet sind. Die gestrichelte Linie für das Bauelement 4 soll lediglich die Lage des Bauelementes 4 in einem verlöteten Endzustand zeigen. In der Darstellung gemäß Figur 2 ist auf der linken Seite eine Kontaktierungsfläche 8 dargestellt, die fest in der Leiterplatte 2 angeordnet ist. Das Augenmerk für die weitere Beschreibung wird jedoch auf die Kontaktierungsfläche 8 auf der rechten Seite gelegt, die in rechteckiger Form ausgestaltet ist und dabei eine Umfangslinie 14 aufweist. Zudem ist um die Kontaktierungsfläche 8 in einem Abstand 16 eine Vertiefungsrinne 12 angeordnet. Die Vertiefungsrinne 12 ist in diesem Beispiel gemäß Figur 2 so tief, dass sie 100 % der Leiterplatte 2 beträgt, das bedeutet, die Leiterplatte ist entlang der Vertiefungsrinne 12 ausgestanzt.

Die Vertiefungsrinne 12 kann beispielsweise durch einen Ausstanzprozess, jedoch auch durch einen Laserschneidprozess oder einen Wasserstrahlprozess herausgearbeitet werden. Die Vertiefungsrinne 12 umläuft drei Seiten des Rechtecks 24, das die Kontaktierungsfläche 8 bildet vollständig und eine vierte Seitenlinie 26 des Rechtecks 24 wird von der Vertiefungsrinne 12 so weit durchlaufen, dass ein Kontaktierungssteg 28 stehen bleibt, der letztendlich den Bereich der Leiterplatte unterhalb der Kontaktierungsfläche 8 trägt und mit dem Rest der Leiterplatte 2 verbindet. Über diesen Kontaktierungssteg 28 ist eine metallische Kontaktierungsleitung 34 geführt.

Diese Maßnahme bewirkt, dass der Bereich der Leiterplatte 2, der unter der Kontaktierungsfläche 8 liegt, in nahezu alle Raumrichtungen flexibel gelagert ist. Hierbei sind als Raumrichtungen die beiden Raumrichtungen, die in der Zeichenebene liegen und mit dem Koordinatensystem X und Y, das hilfsweise in die Figur eingezeichnet ist, zusammenfallen. Die hier nicht dargestellte Z-Richtung, die senkrecht zur Zeichenebene steht, ist bezüglich des Bereichs der Leiterplatte 2, der unter der Kontaktierungsfläche 8 liegt, ebenfalls flexibel gelagert, da hier eine erhebliche Auslenkung in diese Z-Richtung möglich ist. Es ist durchaus möglich, dass bei einem absoluten Betrag von 2 auf 2 mm, die diese Kontaktierungsfläche umfasst, eine Auslenkung in Z-Richtung um 0,5 mm möglich ist, ohne dass es zu einem Schaden an der Leiterplatte 2 kommt. Die Auslenkung in Y-Richtung ist durch die vollständige Umgebung der Seiten des Rechtecks 24, die in Y-Richtung liegen, ebenfalls gegeben. Lediglich die Ausrichtung in X-Richtung gemäß des Koordinatensystems in Figur 2 könnte durch den Kontaktierungssteg 28 etwas behindert sein.

Aus diesem Grund ist es zweckmäßig, dass die Vertiefungsrinne 12 in zwei Abschnitte 30-1 und 30-2 aufgeteilt ist. Der Abschnitt 30-2 der Vertiefungsrinne 12 verläuft nach dieser Ausgestaltung parallel zu der vierten Seitenlinie 26 des Rechtecks 24 und überspannt entlang dieser Linie den Verbindungssteg 28. Dieser zusätzliche Abschnitt 30-2 der Vertiefungsrinne 22 bewirkt somit, dass auch in X-Richtung trotz des starren Verbindungsstegs 28 eine Ausdehnung bzw. eine Flexibilität der Leiterplatte 2 unter der Kontaktierungsfläche 8 möglich ist. Durch diese Maßnahme erhält die Kontaktierungsfläche 8 und somit auch die darauf im Endzustand befindende Lötstelle gegenüber thermischen Ausdehnungen und dem sogenannten Miss-Match der Ausdehnungskoeffizienten der einzelnen verwendeten Materialien eine so hohe Flexibilität, dass ein Reißen oder die Bildung von Rissen in der Lötstelle 6, insbesondere im Lotmaterial 10 unterbunden wird oder sehr unwahrscheinlich wird. Insbesondere kann eine wesentlich höhere Anzahl von Temperaturzyklen dem Bauteil zugemutet werden, was dessen Lebensdauer gegenüber dem Stand der Technik erhöht.

Es ist noch zu beachten, dass die Vertiefungsrinne 12 zwar einen gewissen Abstand 16 von der Kontaktierungsfläche aufweisen können und dies bis zu einem gewissen Grad auch vorteilhaft ist, der Abstand 16 sollte, um die maximale Wirkung der Vertiefungsrinne, wie sie vorhergehend beschrieben ist, zu reduzieren, nicht größer als der maximale Durchmesser 18 der Kontaktierungsfläche 8 sein. Bei dem Rechteck ist der maximale Durchmesser 18 als Diagonale definiert.

In Figur 2 ist die Vertiefungsrinne 12 auch nur bezüglich einer Kontaktierungsfläche 8 vorgesehen, die zweite Kontaktierungsfläche 8`, die das Bauteil 4 kontaktierend aufnimmt, ist mit dieser Maßnahme nicht versehen. Je nach Beanspruchung und je nach Unterschied der Temperaturkoeffizienten der einzelnen verwendeten Materialien kann dies in dieser Form ausreichend sein. Sollte die Flexibilität der Leiterplatte 2 im Bereich der Kontaktierungsfläche 8 nach Berechnung von thermischen Spannungen aufgrund der unterschiedlichen Ausdehnungskoeffizienten nicht ausreichend sein, so kann diese Maßnahme auch für die Kontaktierungsfläche 8' vorgenommen werden. Grundsätzlich wird für die Gesamtstabilität der Leiterplatte 2 die Anzahl und die Länge der Vertiefungsrinne 12 so gering wie möglich gewählt. Dies ist jedoch bei Konstruktion der Leiterplatte 2 durch eine Spannungssimulation berechenbar und anhand dieser einzelnen Berechnungen aus der Konstruktion können die entsprechenden Maßnahmen in Form von Länge und Tiefe bzw. Verlauf der Vertiefungsrinne 12 angepasst werden.

In Figur 3 ist eine ähnliche, vereinfachte Form der Anordnung der Vertiefungsrinne 12 um die Kontaktierungsfläche 8 herum dargestellt. Auch hier beträgt die Länge der Vertiefungsrinne 12 mit den jeweiligen Abschnitten 30-1 und 30-2 mehr als 50 % der gesamten Umfangslinie 14 der rechteckig ausgeformten Kontaktierungsfläche 8. Durch die beiden Abschnitte 30-1 und 30-2 wird ebenfalls ein Kontaktierungssteg 28 ausgebildet, über den eine metallische Kontaktierungsleitung 34 verläuft. Die beiden Abschnitte 30-1 und 30-2 verlaufen ebenfalls wieder in einem Abstand 16 entlang der Kontaktierungsfläche 8, der geringer ist als der maximale Durchmesser 18 der Kontaktierungsfläche 8. Eine derartige flankierende Maßnahme durch die Vertiefungsrinne 12 stellt ihre flexible Wirkung insbesondere in Y-Richtung dar. Eine derartige bezüglich der Figur 2 reduzierte Maßnahme und auch Länge der Vertiefungsrinne 12 kann bei entsprechender Simulation der Spannungszustände, die aufgrund der unterschiedlichen Ausdehnungskoeffizienten vorherrschen, ausreichend sein.

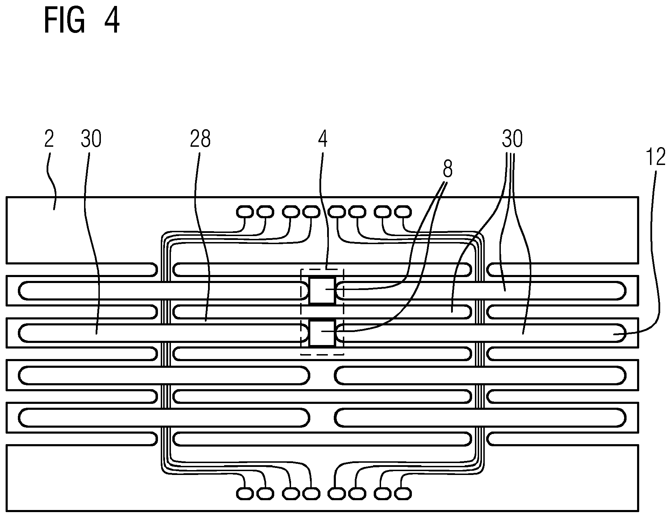

In Figur 4 ist eine weitere beispielhafte Darstellung von Anordnungen von Vertiefungsrinnen 12 mit verschiedenen Abschnitten 30 gegeben. Hier handelt es sich um eine flächenmäßige Dominanz der Vertiefungsrinnen 12 in Bezug auf die Kontaktierungsflächen 8 und die Verbindungsstege 28. Eine derartige Ausgestaltungsform, die eine besonders hohe Flexibilität mit sich bringt, kann bei sehr hohen Anforderungen an die Flexibilität ebenfalls zweckmäßig sein.

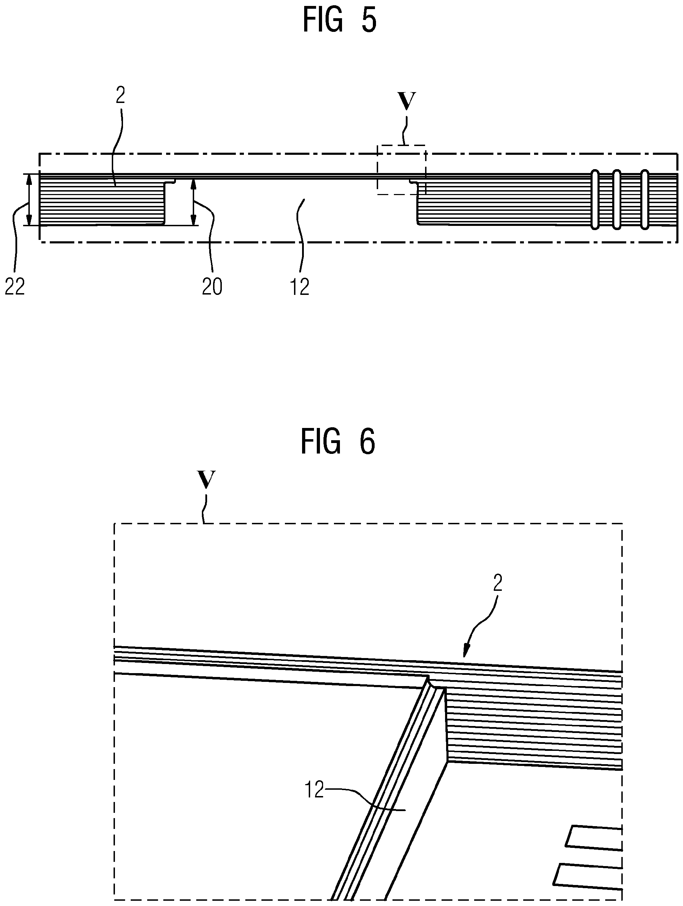

Bisher wurde von einer Vertiefungsrinne ausgegangen, die 100 % der Dicke 22 der Leiterplatte 2 beträgt. In vielen Fällen ist dies die einfachste und die zweckmäßigste Lösung. Es kann jedoch auch eine Anforderung bestehen, dass Bereiche der Leiterplatten 2 in der Vertiefungsrinne 12 bestehen bleiben. In diesem Fall ist es zweckmäßig, wenn die Tiefe 20 der Vertiefungsrinne 12 mindestens 80 % der Dicke 22 der Leiterplatte 2 beträgt, wie dies im Querschnitt der Leiterplatte 2 in Figur 5 veranschaulicht ist. Hierbei ist auch zu erkennen, dass es sich um eine Mehrlagenleiterplatte, eine sogenannte PCB-Leiterplatte, handelt, die aus einer Vielzahl, beispielsweise 15 Laminatschichten aus einem Kunststofflaminat aufgebaut ist, zwischen denen wiederum metallische Kontaktierungsbereiche verlaufen, die hier nicht näher dargestellt sind. Eine Laminatebene eines Leiterplattenlaminates hat dabei beispielsweise eine Dicke von 60 µm, eine Kontaktierungsschicht zwischen den Laminaten dabei eine Dicke von üblicherweise 10 bis 20 µm. Der Ausschnitt V in Figur 5 ist zur besseren Veranschaulichung in einer 3D-Darstellung in Figur 6 noch einmal vergrößert wiedergegeben, um die Ausfräsung der Vertiefungsrinne 12 zu verdeutlichen.

Zur Herstellung einer Leiterplatte 2 gemäß den Figuren 5 und 6 kann es auch zweckmäßig sein, anstatt einem Fräsprozess, der so genau geführt werden muss, dass genau eine definierte Anzahl von Laminaten der Leiterplatte stehen bleiben, diese ganz zu durchstanzen und anschließend eine neue Laminatschicht auf die durchstanzte Leiterplatte 2 aufzubringen, was zu demselben Resultat führt, das in den Figuren 5 und 6 dargestellt ist. Auch die in den Figuren 5 und 6 beschriebenen Vertiefungsrinnen 12 führen zu einer erheblichen Verbesserung der Flexibilität der Bereiche der Leiterplatte 2 unter der Kontaktierungsfläche 8, sodass je nach Anforderungen des simulierten Spannungsbildes und den elektrischen und mechanischen Anforderungen an die Leiterplatte 2 einer dieser Möglichkeiten zur Bildung der Vertiefungsrinne 12 ausgewählt werden kann, es können auch Kombinationen aus vollständig durchstanzten Vertiefungsrinnen 12 und teilweise zu mindestens 80 %igen Vertiefungsrinnen gewählt werden.

### Liste der Bezugszeichen

- 2: Leiterplatte
- 4: Bauelement
- 6: Lötstelle
- 8: Kontaktierungsfläche
- 10: Lotmaterial
- 12: Vertiefungsrinne
- 14: Umfangslinie
- 16: Abstand
- 18: maximaler Durchmesser der Kontaktierungsfläche
- 20: Tiefe
- 22: Leiterplattendicke
- 24: Rechteck
- 26: vierte Seitenlinie
- 28: Kontaktierungssteg
- 30: Abschnitte
- 32: Riss
- 34: metallische Kontaktierungsleitung

## Patentansprüche

1. Leiterplatte mit mindestens einem darauf gelötetem Bauelement (4), wobei das Bauelement (6) mindestens an einer Lötstelle (8), die auf einer Kontaktierungsfläche in der Leiterplattenoberfläche (8) liegt, mittels eines Lotmaterials (10) mit der Leiterplatte (2) verbunden ist, **dadurch gekennzeichnet, dass** um die Kontaktierungsfläche (8) ein Vertiefungsrinne (12) in der Leiterplatte (2) verläuft, die die Kontaktierungsfläche (8) zu mindestens 50 % ihrer Umfangslinie (14) in einem Abstand (16) umläuft, der nicht größer als der maximale Durchmesser (18) der Kontaktierungsfläche (8) ist.

2. Leiterplatte nach Anspruch 1, **dadurch gekennzeichnet, dass** die Vertiefungsrinne (12) eine Tiefe (20) aufweist, die mindestens 80 % der Leiterplattendicke (22) beträgt.

3. Leiterplatte nach Anspruch 2, **dadurch gekennzeichnet, dass** die Tiefe (20) der Vertiefungsrinne (12) 100 % der Leiterplattendicke (22) beträgt.

4. Leiterplatte nach einem der vorhergehenden Ansprüche, **dadurch gekennzeichnet, dass** die Vertiefungsrinne (12) die Umfangslinie (14) der Kontaktierungsfläche (8) zu mindestens 70 %, bevorzugt mindestens zu 80 % umläuft.

5. Leiterplatte nach einem der vorhergehenden Ansprüche, **dadurch gekennzeichnet, dass** die Kontaktierungsfläche (8) rechteckig ausgestaltet ist und die Vertiefungsrinne (12) mindestens an drei Seiten des Rechtecks (24) flankierend verläuft.

6. Leiterplatte nach einem der vorhergehenden Ansprüche, **dadurch gekennzeichnet, dass** die Kontaktierungsfläche (8) rechteckig ausgestaltet ist und die Vertiefungsrinne (12) an vier Seiten des Rechtecks (24) flankierend verläuft, wobei an einer vierten Seitenlinie (26) ein Kontaktierungssteg (28) vorgesehen ist.

7. Leiterplatte nach einem der vorgehenden Ansprüche, **dadurch gekennzeichnet, dass** die Vertiefungsrinne (8) mehrere voneinander getrennte Abschnitte (30) aufweist.

8. Leiterplatte nach Anspruch 6 und 7, **dadurch gekennzeichnet, dass** zwischen der mit dem Steg verbundenen vierten Seitenlinie (26) der Kontaktierungsfläche (8) ein zweiter Abschnitt (30-2) der Vertiefungsrinne (8) vorgesehen ist, die im Wesentlichen parallel zur vierten Seitenline (26) verläuft.

9. Leiterplatte nach Anspruch 8, **dadurch gekennzeichnet, dass** der zweite Abschnitt (30-2) der Vertiefungsrinne (8) sich mindestens über die Länge der vierten Seitenlinie (26) erstreckt, die mit dem Kontaktierungssteg (28) in Verbindung steht.

10. Leiterplatte nach Anspruch 9, **dadurch gekennzeichnet, dass** der zweite Abschnitt (30-2) der Vertiefungsrinne (8) mindestens der Länge der vierten Seitenlinie (26) entspricht.
